# EUROPEAN PATENT APPLICATION

(11) **EP 4 657 523 A1**
(43) Date of publication of application: **03.12.2025**
(21) Application number: 24178904.9
(22) Date of filing: 29.05.2024
(51) Int. Cl.: H01L 23/498, H01L 23/538, H01L 21/48

(54) **ADDITIVE MANUFACTURING OF FAN-OUT PACKAGES**

(71) Applicant: Nederlandse Organisatie voor toegepast-natuurwetenschappelijk Onderzoek TNO, 2595 DA 's-Gravenhage (NL); Stichting Chip Integration Technology Center, 6534 AT Nijmegen (NL)
(72) Inventor: SMITS, Edsger Constant Pieter, 2595 DA 's-Gravenhage (NL); RUBINGH, Jan-Eric Jack Martijn, 2595 DA 's-Gravenhage (NL); CHIAPPINI, Francesca, 2595 DA 's-Gravenhage (NL); FARRUGIA, Mark Luke, 6534 AT Nijmegen (NL)
(74) Representative: V.O.

(57) **Abstract**

A method of manufacturing an electronic stack (10). A substrate (S) is provided with a first seed layer (11). A first dielectric layer (12) is provided at least partially covering the first seed layer (11). At least one vertical passage is formed through the first dielectric layer (12) to leave a respective exposed area of the first seed layer (11) free of the electrically insulating material. Additional electrically conductive material (11n) is grown onto the exposed area of the first seed layer (11), filling an inside of the vertical passage with the additional electrically conductive material (11n) to form a vertical interconnect (V) of the electronic stack (10) through the first dielectric layer (12). The electronic stack (10) may be diced to form a fan-out panel package. An electronic component (1) may be arranged as part of the electronic stack (10) to form a fan-out package.

## Description

### TECHNICAL FIELD AND BACKGROUND

The present disclosure relates to methods and systems for manufacturing an electronic stack, e.g. for packaging an electronic component, and packages resulting from such methods and systems.

Fan-out panel level processing (FOPLP) and fan-out wafer level processing (FOWLP) are manufacturing technologies that redistributes the connections of an electronic component, e.g. semiconductor die, over a larger area using a panel format, offering significant advantages over traditional packaging methods. For example, by creating a redistribution layer (RDL), additional metal and dielectric layers may be added to expand the input/output connections from the die, thereby enhancing electrical and thermal performance. In FOPLP, vias play a critical role in establishing vertical electrical connections between different layers of the semiconductor package. They enable the redistribution of input/output connections from the semiconductor die to the larger panel area, facilitating the integration of multiple dies and enabling the electrical connections of the package. Efficient via manufacturing is crucial for ensuring reliable contacts in semiconductor packages in general. For vertical power devices in particular vias connecting the top and the bottom of packages are fundamental for the functionality and efficiency of the devices. However, in the domain of discrete power devices, the adoption of FOPLP has been hindered by several challenges associated with manufacturing of vertical interconnects, also referred to as vias. For example, the subtractive processes for generating vias may be slow and costly, and the aspect ratio and size of vias may be limited due to the constraints of laser drilling and/or photolithography and/or plating.

There is yet a need for improved methods and systems for manufacturing electronic stacks having vertical interconnects between different layers and/or electronic connections.

### SUMMARY

Aspects of the present disclosure relate to methods and systems for manufacturing an electronic stack. A substrate is provided with a seed layer. The seed layer is formed as a patterned layer of electrically conductive material. A dielectric layer is provided to at least partially cover the first seed layer. The dielectric layer is formed as a patterned layer of electrically insulating material. At least one vertical passage is formed through the dielectric layer to leave a respective exposed area of the first seed layer, at the bottom of the vertical passage, free of the electrically insulating material. Additional electrically conductive material is grown onto the exposed area of the seed layer, filling an inside of the vertical passage with the additional electrically conductive material to form a vertical interconnect of the electronic stack through the first dielectric layer. By providing a substrate with a seed layer formed as a patterned layer of electrically conductive material, the method ensures precise initial layer formation and/or minimal use of material i.e. the materials is present only where it is needed. By providing a dielectric layer at least partially covering the first seed layer and forming vertical passages through the dielectric layer to expose the seed layer, the method facilitates the creation of reliable vertical interconnects. By growing additional electrically conductive material onto the exposed area of the first seed layer and filling the vertical passages, robust electrical connections through the dielectric layer are established, enhancing the stack's vertical integration and/or electrical performance.

By applying the seed layer and/or dielectric layer using a respective printing process, manufacturing efficiency and patterning precision are improved. By using an electroplating process to grow the additional conductive material onto the exposed area of the first seed layer, high-quality and uniform deposition is achieved. Further conductive material extending through the first dielectric layer ensures continuous electrical pathways. By optionally grinding the top side area of the electronic stack to make the conductive material flush with the dielectric layer, a smooth and planar surface is created, facilitating subsequent layer applications.

By embedding at least one electronic component in the first dielectric layer before its application, the method allows for integrated component packaging and protection. By applying one or more electronic components to the substrate using a temporary adhesive, the component(s) and/or other parts, e.g. layers, may be easily released and/or lifted from the substrate. By using a (temporary) adhesive that is non-sticky, at under subsequent processing conditions (e.g. room temperature), one or more (further) layers may be easily applied using various techniques, including screen printing. For example, one or more of the seed layer and/or dielectric layer may be applied onto a non-sticky previously applied adhesive layer using screen printing while the adhesive holds one or more electronic components to the substrate. Alternatively, or in addition, a (temporary) adhesive material may be applied selectively below the component and/or the component may be applied later.

By forming vertical passages through the dielectric layer to expose areas of the electronic component, and by using the same electroplating process to fill these passages, seamless integration and electrical connection of components are ensured. By arranging the patterned seed layer to form a first circuit layer in a horizontal plane and using the vertical interconnects, a versatile and interconnected circuit architecture is created. By forming a second circuit layer by applying a second seed layer and growing additional conductive material through electroplating, multilayer circuit configurations are achieved. By embedding the second circuit layer in a second dielectric layer, further protection and insulation are provided. By lifting and flipping the electronic stack to expose the bottom side, and applying additional conductive material, further electrical and/or thermal connections may be applied. By providing a third dielectric layer with vertical passages to expose backside areas of the seed layers, and growing conductive material in these passages, additional vertical interconnects can be formed, further enhancing stack connectivity. The top surface may be covered with a final dielectric layer, e.g. with optional contacts to create a protected package.

Debonding of the structured layer from the carrier may be performed through mechanical and/or optical means. Once debonded the structured layer may be flipped and rebonded to further process the backside of the package. For example, this may be done through repeating one or more of the processes described herein. Optionally, a redistribution layer (RDL) through photolithography and/or semi additive plating may be employed to achieve high resolution interconnection.

By dicing the electronic stack into one or more packages with externally exposed electrical connections, efficient and compact packaging solutions with robust internal and external connections are realized. These connections may ensure reliable interfacing with external systems and enhance the overall performance of the embedded electronic components.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A - 1D illustrates steps in manufacturing an electronic stack including a vertical interconnect;
FIGs 2A - 2D illustrate further steps in manufacturing an electronic stack including a second circuit layer;
FIGs 3A - 3D illustrate further steps in manufacturing an electronic stack, including a first circuit layer on a backside of the stack;
FIGs 4A - 4D illustrate further steps in manufacturing an electronic stack, including further vertical interconnect, lifting the stack from the substrate, and dicing the stack;

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

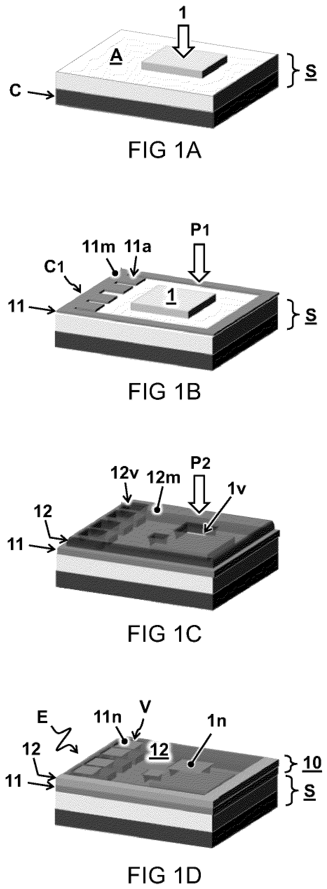

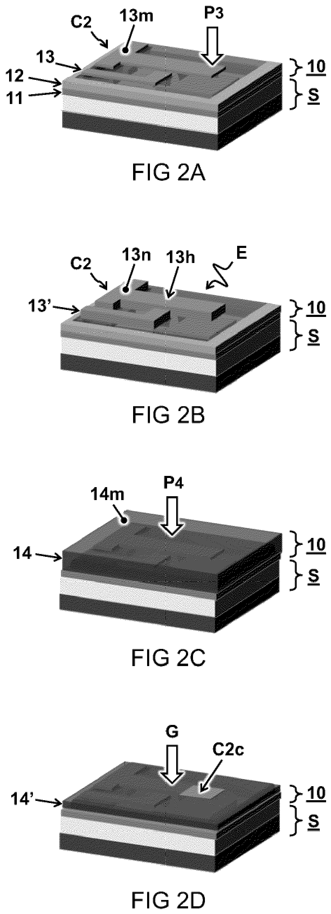

FIGs 1A - 1D illustrates steps in manufacturing an electronic stack 10 including a vertical interconnect "V". Optionally the steps of FIGs 1A through 1D can be repeated to create one or more additional layers. For example, these steps may be repeated before moving to the processes described in FIGs 2A-2D, et cetera.

In some embodiments, e.g. as shown in FIG 1B, a substrate "S" is provided with a first seed layer 11. In the embodiment shown, the first seed layer 11 is formed as a patterned layer of electrically conductive material 11m. Preferably, copper or silver is used as the electrically conductive material (e.g. 11m and/or 11p, etc). Also other or further conductive materials may be used. In other or further embodiments, e.g. as shown in FIG 1C, a first dielectric layer 12 is provided. In one embodiment, the first dielectric layer 12 at least partially covers the first seed layer 11. In another or further embodiment, the first dielectric layer 12 is formed as a patterned layer of electrically insulating material 12m. Preferably, an epoxy molding compound (EMC), e.g. comprising and/or (essentially) consisting of epoxy loaded with an inorganic filler, is used as the electrically insulating material (e.g. 12m, 14m, and/or 15m). Also other or further electrically insulating materials may be used.

In some embodiments, at least one vertical passage 12v is formed through the first dielectric layer 12. The vertical passage 12v may leave a respective exposed area 11a of the first seed layer 11, at a bottom of the vertical passage 12v, free of the electrically insulating material 12m. In other or further embodiments, e.g. as shown in FIG 1D additional electrically conductive material 11n is grown onto the exposed area 11a of the first seed layer 11. Accordingly, an inside of the vertical passage 12v may be filled with the additional electrically conductive material 11n. In this way a vertical interconnect "V" of the electronic stack 10 may be formed through the first dielectric layer 12.

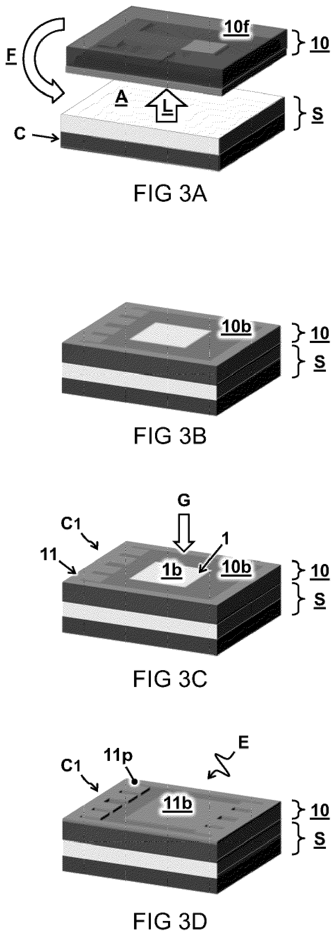

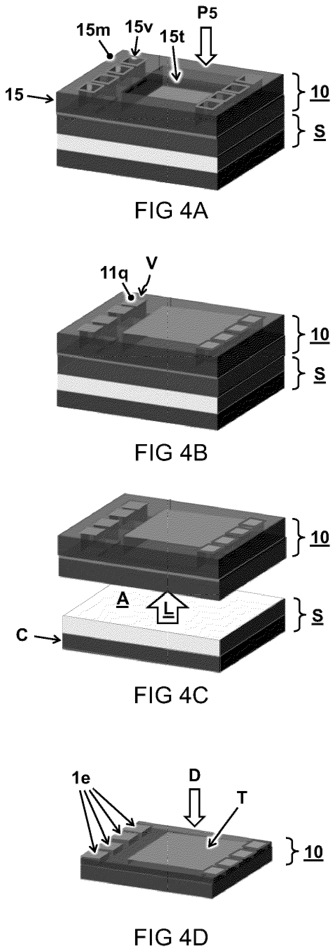

In a preferred embodiment, one or more layers such as the seed layers (e.g. 11 in FIG 1B; 13 in FIG 2A; 11b in FIG 3D) and/or dielectric layers (e.g. 12 in FIG 1C; 14 in FIG 2C; 15 in FIG 4A) are applied by respective printing (P1,P2,P3,P4,P5), most preferably screen printing. For example, for the seed layer, a screen with the desired pattern is created, and conductive ink or paste is applied through the screen onto the substrate. The ink is then cured or sintered to form the conductive pattern. For the dielectric layer, a screen with the desired pattern is created, and dielectric ink or paste is applied through the screen onto the seed layer, leaving specific areas uncovered to form the vertical passages. The dielectric material is then cured. By screen printing these layers, high throughput and cost-effective manufacturing can be achieved due to the simplicity and speed of the process.

Also, other or further printing methods can be used, such as inkjet printing. For example, for the seed layer, conductive ink is directly deposited onto the substrate using an inkjet printer to form the patterned layer. The ink is then cured or sintered. For the dielectric layer, dielectric ink is directly deposited onto the seed layer using an inkjet printer to form the patterned layer, selectively leaving areas uncovered to create the vertical passages. The dielectric ink is then cured. By inkjet printing these layers, precise and flexible patterning can be achieved, allowing for complex and high-resolution designs. Also, other or further methods of applying one or more layers, such as the seed layer(s) and/or dielectric layer(s) can be envisaged.

In a preferred embodiment, the further conductive material 11n is grown onto the exposed area 11a of the first seed layer 11 by means of an electroplating process E. The inventors find that electroplating is particularly effective and controllable to fill the vertical passage 12v from the bottom upwards by growing the additional electrically conductive material 11n starting from the exposed area 11a of the first seed layer 11. For example, the electronic stack 10, or at least the first seed layer 11, is immersed in an electrolyte solution containing ions of the additional electrically conductive material 11n to be deposited. For example, the first seed layer 11 may act as a cathode and a metal anode, e.g. formed of the same material as the ions in the solution, may be connected to a power supply. The anode may dissolve into the solution, replenishing the metal ions. When current is applied between the seed layer and the metal anode, metal ions in the solution may deposit onto the seed layer, gradually building up the desired thickness of the conductive material inside the vertical passage 12v. Alternatively, or additionally, also other ways of growing electrically conductive material can be envisaged such as electroless plating. In any case, the exposed area of the seed layer may be advantageously used as a target area for growing of the additional electrically conductive material on top.

Preferably, the further conductive material 11n is grown to extend at least partially through the first dielectric layer 12. In some embodiments, the further conductive material 11n is grown until it is flush with a top side area of the surrounding first dielectric layer 12. In other or further embodiments, a thickness or height of the first dielectric layer 12 and/or further conductive material 11n is reduced after application. For example, a top side area may be grinded to make the further conductive material 11n flush with the first dielectric layer 12.

In some embodiments, e.g. as shown in FIG 1A, the electronic stack 10 is provided with at least one electronic component 1. For example, the electronic component 1 comprises an integrated circuit and/or chip and/or semiconductor die. Preferably, the electronic component 1 is adhered to the substrate "S". In some embodiments, the substrate "S" comprises a carrier substrate "C" which is provided with an adhesive layer "A". Accordingly the electronic component 1 may be held by the adhesive layer "A". Also other parts of the electronic stack 10 may be held by the adhesive layer "A". Preferably, a temporary adhesive is used, so that the electronic stack 10 can be (later) released from the substrate "S". For example, the adhesive layer "A" comprises a thermally debonding adhesive material. Accordingly the adhesive force may be removed or reduced by thermally activating the adhesive layer "A". Also other or further types of temporary adhesive materials may be used, e.g. photonically debonding materials. For example, the carrier substrate "C" may be a transparent carrier, e.g. glass substrate, allowing the electronic stack 10 to be debonded by shining a light beam through the transparent carrier. It will be understood that the light beam may also be used to thermally and/or photonically debond the adhesive material. Preferably, the adhesive layer "A" is non-sticky during subsequent processing steps, e.g. (screen) printing of seed layer(s) and/or dielectric layers(s). For example, the adhesive layer "A" is sticky while bonding the electronic component 1, e.g. at an elevated temperature, and non-sticky while (screen) printing the seed layer(s) and/or dielectric layers(s), e.g. at room temperature.

Preferably, the electronic component 1 is placed onto the substrate "S" before applying the first dielectric layer 12. Accordingly, the electronic component 1 is at least partially embedded by the electrically insulating material 12m of the first dielectric layer 12. In some embodiments, e.g. as shown in FIG 1C, the patterned layer of electrically insulating material 12m forms at least one vertical passage 1v through the first dielectric layer 12 to leave a respective area of the electronic component 1 exposed, free of the electrically insulating material 12m. In one embodiment, the at least one additional vertical passage 1v is filled with electrically conductive material to form an electrical connection with the electronic component 1. For example, the least one additional vertical passage 1v may be at least partially filled by printing, or any other deposition method. It can also be envisaged to apply a seed layer extending inside the least one additional vertical passage 1v and/or using an electroplating process E for further filling the vertical passage 1v to the electronic component 1. In one embodiment, the same electroplating process E used for growing the additional electrically conductive material 11n filling the vertical passage 12v to the first seed layer 11 may also be used to fill the vertical passage 1v to the electronic component 1. Alternatively, or additionally, the first dielectric layer 12 may be grinded back to (re)expose one or more areas of the electronic component 1.

In one embodiment, e.g. as shown, the electronic component 1 is placed before applying the first seed layer 11. In another or further embodiment (not shown), one or more electronic components are placed after applying the first seed layer 11. In some embodiments, the electronic component is placed onto the substrate "S" by a pick and place method, e.g. robotic arm. Also other methods of placing the electronic component 1 can be envisaged such a light induced forward transfer of the electronic component from a donor substrate onto the destination substrate "S". It can also be envisaged to apply the electronic component 1 by lamination.

In one embodiment, e.g. as shown, the electronic component 1 is (at least initially) placed separate from the first seed layer 11, i.e. not electrically connected to the first seed layer 11. In another or further embodiment (not shown), one or more electronic components are electrically connected to the first seed layer 11, e.g. placed on an electrode part of the first seed layer 11; or the first seed layer 11 is applied after the electronic component 1 to form an electrical contact therewith. In some embodiments (not shown), the first seed layer 11 is grown to form a circuit layer before applying one or more electronic components. In other or further embodiments, the first seed layer 11 is grown after applying one or more electronic components.

In some embodiments, the patterned layer of electrically conductive material 11m of the first seed layer 11 is arranged to form (at least part of) a first circuit layer C1 of the electronic stack 10. Typically, the first circuit layer C1 is arranged in a horizontal plane of the electronic stack 10, transverse to the vertical interconnect "V". In other or further embodiments, the first circuit layer C1 is formed by growing additional electrically conductive material 11p on top of the first seed layer 11 before applying the first dielectric layer 12 (before the step of FIG 1C) and/or on a bottom of the first seed layer 11, after separating the electronic stack 10 from the substrate "S" to expose the bottom of the first seed layer 11 (e.g. as shown in FIGs 3A-3D).

FIGs 2A - 2D illustrate further steps in manufacturing an electronic stack 10 including a second circuit layer C2. Optionally the steps of FIGs 2A through 2D and/or the steps of FIGs 1A through 2D can be repeated to create one or more additional layers. For example, these steps may be repeated before moving to the processes described in FIGs 3A through 3D.

In some embodiments, a second circuit layer C2 is provided on top of the first dielectric layer 12. In one embodiment, the vertical interconnect "V" through the first dielectric layer 12 forms an electrical connection between the second circuit layer C2 on top of the first dielectric layer 12 and the first circuit layer C1 below the first dielectric layer 12. In another or further embodiment, wherein the second circuit layer C2 forms at least one electrical connection between a part of the first circuit layer C1, via the vertical interconnect "V" through the first dielectric layer 12, and a top side electrical connection of the electronic component 1. For example, the second circuit layer C2 comprises a horizontal circuit lane 13h interconnecting the vertical interconnect "V" of the first circuit layer C 1 with a top side electrical connection of the electronic component 1. Optionally, the top side electrical connection of the electronic component 1 may be accessed via a second vertical interconnect through the first dielectric layer 12, e.g. formed through the passage 1v as shown in FIG 1C.

In some embodiments, e.g. as shown in FIGs 2A and 2B, the second circuit layer C2 is formed by applying a second seed layer 13 is formed as a patterned layer of electrically conductive material 13m, and growing additional electrically conductive material 13n onto the second seed layer 13 by means of an electroplating process E. Electroless plating may also be possible. Advantageously, the same or similar process can be used as for applying and/or growing the first seed layer 11. Of course also other or further ways of forming the second circuit layer C2 can be envisaged, e.g. any of the aforementioned processes for applying an electrically conductive layer.

In other or further embodiments, e.g. as shown in FIG 2C, a second dielectric layer 14 is provided for covering the second circuit layer C2. For example, the second circuit layer C2 is at least partially embedded in an electrically insulating material 14m of the second dielectric layer 14. In one embodiment, e.g. as shown in FIG 2D, the second dielectric layer 14 is grinded G to form a flattened and/or thinned dielectric cover layer 14'. Alternatively, such grinding may not be necessary. In some embodiments, the grinding and/or other process may (re)expose one or more conductive contacts C2c with the second circuit layer C2.

FIGs 3A - 3D illustrate further steps in manufacturing an electronic stack 10, including further parts of the first circuit layer C1 on a backside 10b of the stack 10.

In some embodiments, e.g. as shown in FIG 3A, the electronic stack 10 is lifted (L) from the substrate "S". Preferably, the electronic stack 10 is released from the substrate "S" by thermal and/or photonic debonding. For example, light is directed through a transparent carrier C to weaken and/or release adhesion of an adhesive layer "A" holding the electronic stack 10. The electronic stack 10 may then be picked up from the substrate "S", e.g. using any suitable tool.

In other or further embodiments, e.g. as shown in FIG 3B, the electronic stack 10 is flipped (F) upside down to expose a bottom side 10b of the electronic stack 10, e.g. expose a bottom side of the first seed layer 11 and/or electronic component 1. The upside-down electronic stack 10 may be adhered with the previous front side 10f to the same substrate "S", or may be adhered onto another substrate (not shown). For example, the electronic stack 10 may be (re)adhered using the same and/or other thermal and/or photonic debonding adhesive material. Alternatively, or additionally, the electronic stack 10 may be initially, or after lifting and/or flipping be adhered to an electronic substrate and/or stack which may form part of a final electronic device (not shown). In some embodiments, e.g. as shown in FIG 3C, the bottom side 10b of the electronic stack 10 is grinded (G), e.g. to flatten the bottom side 10b and/or reduce thickness of one or more layers on the bottom side 10b. Alternatively, grinding may not be necessary.

Advantageously, the relatively flat bottom side (with or without grinding) may be especially suitable for further processing steps. In some embodiments, additional conductive material 11b, e.g. another seed layer, is applied on the bottom side 10b of the stack 10. For example, this may be used to electrically connect the bottom side 1b of the electronic component 1. Alternatively, or additionally, the conductive seed layer and/or further material may be used to form a heat conductor and/or heat sink connected to the electronic component 1. For example, the electronic stack 10 may provide top cooling / bottom electrical contacts, dual-side cooling, and/or dual side electrical contacts. Optionally, a further electroplating process E is applied to grow additional electrically conductive material 11p onto the bottom of the first seed layer 11 and/or onto the additional conductive material 11b/ further seed layer. Alternatively, or in addition, the relatively flat bottom side may be used for other or further processing. For example, a redistribution layer (RDL) via photolithography and/or photoresist and semi additive plating processes may be applied.

FIGs 4A - 4D illustrate further steps in manufacturing an electronic stack 10, including forming of further vertical interconnects "V", lifting the stack 10 from the substrate "S", and dicing the stack 10. Optionally the steps of FIGs 4A and 4B and/or the steps of FIGs 3C to 4B (optionally skipping FIG 3D) can be repeated to create one or more additional layers. For example, these steps may be repeated before moving to the processes described in FIG 4C.

In some embodiments, e.g. as shown in FIG 4A, a third dielectric layer 15 is provided at least partially covering the bottom side 10b of the electronic stack 10. In one embodiment, the third dielectric layer 15 is formed as a patterned layer of electrically insulating material 15m. In another or further embodiment, at least one vertical passage 15v is formed through the third dielectric layer 15 to leave a respective exposed backside area of the first seed layer 11 and/or further seed layer 11b applied at the bottom side 10b of the electronic stack 10 free of the electrically insulating material 15m. In other or further embodiments, e.g. as shown in FIG 4B, additional electrically conductive material 11q is grown onto the respective exposed backside area, filling an inside of the vertical passage 15v with the additional electrically conductive material 11q to form a vertical interconnect "V" of the electronic stack 10 through the third dielectric layer 15.

In some embodiments, e.g. as shown in FIG 4C, the electronic stack 10 is (again) lifted (L) from the substrate "S", e.g. in the same or similar way as described with reference to FIG 3A. In other or further embodiments, e.g. as shown in FIG 4D, the electronic stack 10 is diced D to form one or more fan-out level packages. Preferably, each package has a set of externally exposed electrical connections 1e which connect, via one or more vertical interconnects V, to respective electrical contact points of an electronic component 1 embedded inside the package. Most preferably, one or more of the externally exposed electrical connections 1e of the package are arranged facing an opposite side from their corresponding one or more electrical contact points of the electronic component 1. For example, one or more of the externally exposed electrical connections 1e of the package are arranged facing a bottom side of the package and one or more of the respective electrical contact points of the electronic component 1 are arranged facing a top side of the electronic component 1 and/or package, opposite the bottom side. These top and bottom side orientations may also be reversed. Alternatively, or additionally, one or more of the externally exposed electrical connections 1e of the package and corresponding electrical contact point of the electronic component 1 are arranged facing the same, e.g. both facing the top side or both facing the bottom side.

In some embodiments, the dicing comprises cutting one or more electrical interconnections, used for the electroplating process, resulting in separated electrical circuit parts and/or multiple independent electrical connections 1e with the electronic component 1. In other or further embodiments, e.g. as shown in FIG 4D, also a thermal connection T to the electronic component 1 may be formed, separate from the electrical connections 1e. For example, this may be formed by filling the opening 15t as shown in FIG 4A. In principle, the thermal connection T may be on the same and/or opposite side as the electrical connections 1e.

For the purpose of clarity and a concise description, features are described herein as part of the same or separate embodiments. However, it will be appreciated that the scope of the invention may include embodiments having combinations of all or some of the features described. For example, while embodiments were shown for forming a fan-out panel level package with top side connections to an electronic component, also alternative ways may be envisaged by those skilled in the art having the benefit of the present disclosure for achieving a similar function and result. For example, also fan-out wafer level processing may be used. For example, also a face down process for chip integration may be used. For example, the methods of applying seed layers and dielectric layers using printing and/or electroplating may be combined or split up into one or more alternative components. Alternatively, or in addition to providing the electronic stack with at least one electronic component, adhered by temporary adhesive to the substrate, before applying the first dielectric layer, it can also be envisaged to first make or leave a pocket for the component in the dielectric layer EMC and then place the component, The various elements of the embodiments as discussed and shown offer certain advantages, such as improved manufacturing efficiency, cost-effectiveness, and enhanced electrical performance. Of course, it is to be appreciated that any one of the above embodiments or processes may be combined with one or more other embodiments or processes to provide even further improvements in finding and matching designs and advantages. It is appreciated that this disclosure offers particular advantages to the manufacturing of advanced semiconductor packages with vertical interconnects, and in general can be applied for any application wherein reliable and efficient vertical electrical connections are required.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise.

## Claims

1. A method of manufacturing an electronic stack (10), the method comprising
providing a substrate (S) with a first seed layer (11), wherein the first seed layer (11) is formed as a patterned layer of electrically conductive material (11m);
providing a first dielectric layer (12) at least partially covering the first seed layer (11), wherein the first dielectric layer (12) is formed as a patterned layer of electrically insulating material (12m),
wherein at least one vertical passage (12v) is formed through the first dielectric layer (12) to leave a respective exposed area (11a) of the first seed layer (11), at a bottom of the vertical passage (12v), free of the electrically insulating material (12m); and
growing additional electrically conductive material (11n) onto the exposed area (11a) of the first seed layer (11), filling an inside of the vertical passage (12v) with the additional electrically conductive material (11n) to form a vertical interconnect (V) of the electronic stack (10) through the first dielectric layer (12).

2. The method according to the preceding claim, wherein the further conductive material (11n) is grown onto the exposed area (11a) of the first seed layer (11) by means of an electroplating process (E), wherein the further conductive material (11n) extends at least partially through the first dielectric layer (12).

3. The method according to any of the preceding claims, wherein the seed layer (11) and/or dielectric layer (12) are applied in a respective pattern using a respective printing process (P1,P2).

4. The method according to any of the preceding claims, wherein a top side area of the electronic stack (10) is grinded to make the grown additional conductive material (11n) flush with the first dielectric layer (12).

5. The method according to any of the preceding claims, wherein the electronic stack (10) is provided with at least one electronic component (1), adhered by temporary adhesive (A) to the substrate (S), before applying the first dielectric layer (12), wherein the electronic component (1) is at least partially embedded by the electrically insulating material (12m) of the first dielectric layer (12).

6. The method according to the preceding claim, wherein the patterned layer of electrically insulating material (12m) forms at least one additional vertical passage (1v) through the first dielectric layer (12) to leave a respective area of the electronic component (1) exposed, free of the electrically insulating material (12m), and the at least one additional vertical passage (1v) is filled with electrically conductive material to form an electrical connection with the electronic component (1).

7. The method according to any of the preceding claims, wherein the patterned layer of electrically conductive material (11m) of the first seed layer (11) is arranged to form a first circuit layer (C 1) of the electronic stack (10), wherein the first circuit layer (C1) is arranged in a horizontal plane of the electronic stack (10), transverse to the vertical interconnect (V).

8. The method according to the preceding claim, wherein the first circuit layer (C1) is further formed by growing additional electrically conductive material (11p) on top of the first seed layer (11) before applying the first dielectric layer (12) and/or on a bottom of the first seed layer (11), after separating the electronic stack (10) from the substrate (S) to expose the bottom of the first seed layer (11).

9. The method according to any of the two preceding claims, wherein a second circuit layer (C2) is provided on top of the first dielectric layer (12), wherein the vertical interconnect (V) through the first dielectric layer (12) forms an electrical connection between the second circuit layer (C2) on top of the first dielectric layer (12) and the first circuit layer (C1) below the first dielectric layer (12).

10. The method according to the preceding claim, wherein the second circuit layer (C2) forms at least one electrical connection between a part of the first circuit layer (C1), via the vertical interconnect (V) through the first dielectric layer (12), and a top side electrical connection of the electronic component (1).

11. The method according to the preceding claim, wherein a second dielectric layer (14) is provided for covering the second circuit layer (C2), wherein the second circuit layer (C2) is embedded in an electrically insulating material (14m) of the second dielectric layer (14).

12. The method according to any of the preceding claims, wherein the electronic stack (10) is lifted (L) from the substrate (S) and flipped (F) upside down to expose a bottom side (10b) of the electronic stack (10), wherein additional conductive material (11b), is applied on the bottom side (10b) of the stack (10) to electrically and/or thermally connect the bottom side (1b) of the electronic component (1).

13. The method according to the preceding claim, wherein a third dielectric layer (15) is provide at least partially covering the bottom side (10b) of the electronic stack (10), wherein the third dielectric layer (15) is formed as a patterned layer of electrically insulating material (15m), wherein at least one vertical passage (15v) is formed through the third dielectric layer (15) to leave a respective exposed backside area of the first seed layer (11) and/or further seed layer (11b) applied at the bottom side (10b) of the electronic stack (10) free of the electrically insulating material (15m); and growing additional electrically conductive material (11q) onto the respective exposed backside area, filling an inside of the vertical passage (15v) with the additional electrically conductive material (11q) to form a vertical interconnect (V) of the electronic stack (10) through the third dielectric layer (15).

14. The method according to any of the preceding claims, wherein the electronic stack (10) is diced (D) to form one or more fan-out packages, each package having a set of externally exposed electrical connections (1e) which connect, via one or more vertical interconnects (V), to respective electrical contact points of an electronic component (1) embedded inside the package, wherein the externally exposed electrical connections (1e) of the package are arranged on a side of the package facing opposite with respect to a side of the respective electrical contact points on the electronic component (1).

15. A fan-out package manufactured according to the method of any of the preceding claims.
